# EUROPEAN PATENT SPECIFICATION

(11) **EP 3 547 815 B1**
(45) Date of publication and mention of the grant of the patent: **30.11.2022**
(21) Application number: 16922059.7
(22) Date of filing: 22.11.2016
(51) Int. Cl.: H05K 13/00, H05K 13/02, H05K 13/08, H05K 13/04

(54) **MOUNTING MACHINE**
MONTAGEMASCHINE
MACHINE DE MONTAGE

(43) Date of publication of application: 02.10.2019
(73) Proprietor: Fuji Corporation, Chiryu-shi, Aichi 472-8686 (JP)
(72) Inventor: SUGIYAMA, Hiroshi, Chiryu Aichi (JP); YAMAZAKI, Atsushi, Chiryu Aichi (JP)
(74) Representative: Grünecker Patent- und Rechtsanwälte PartG mbB
(86) International application number: PCT/JP2016/084561
(87) International publication number: WO 2018/096574

(56) References cited:
- JP-A- 2004 281 468
- JP-A- 2006 222 255
- JP-A- 2008 098 411
- JP-A- 2010 232 544
- JP-A- 2015 103 774
- JP-A- 2016 018 970

## Description

### Technical Field

The present invention relates to a mounting machine configured to pick up a supplied component at a supply position with a holding tool and mount the component.

### Background Art

The mounting machine usually includes a supply device configured to supply a component at a supply position and a mounting head including a holding tool configured to pick up the component supplied by the supply device and executes a mounting of the component held by the holding tool. The following patent literature describes an example of such a mounting machine.

### Patent Literature

Patent Literature 1: JP-A-2010-73977 Additionally, JP2010232544 discloses an electronic component mounting apparatus comprising a light sensor. The apparatus prevents a suction nozzle from breaking by colliding with a dropped electronic component.

### Summary of the Invention

### Technical Problem

In the mounting machine having the above structure, if the holding tool fails to properly pick up a component, the component may fall on or near the supply position so that the mounting head may come into contact with the fallen component. The present invention has been made in view of such situations, and an object of the present invention is to prevent the contact between a mounting head and a component that falls on or near a supply position.

### Solution to Problem

To solve the problem described above, the description discloses a mounting machine according to claim 1.

### Advantageous Effect of the Invention

According to the disclosure, it is determined whether any component exists at or near the supply position, which makes it possible to prevent the contact between the mounting head and any component that falls on or near the supply position.

### Brief Description of Drawings

[Fig. 1] Fig. 1 is a view showing an electronic component mounter.
[Fig. 2] Fig. 2 is a view showing a mounting head.
[Fig. 3] Fig. 3 is a view showing a supply device as viewed from a top thereof.
[Fig. 4] Fig. 4 is a view showing the supply device as viewed from a side thereof.
[Fig. 5] Fig. 5 is a block diagram showing a control device.
[Fig. 6] Fig. 6 is a view showing the supply device as viewed from a side thereof.
[Fig. 7] Fig. 7 is a view showing a supply device of an alternative embodiment as viewed from a top thereof.

### Description of Embodiments

Hereinafter, referring to drawings, embodiments of the present invention will be described in detail as a mode for carrying out the invention.

### Configuration of Electronic Component Mounter

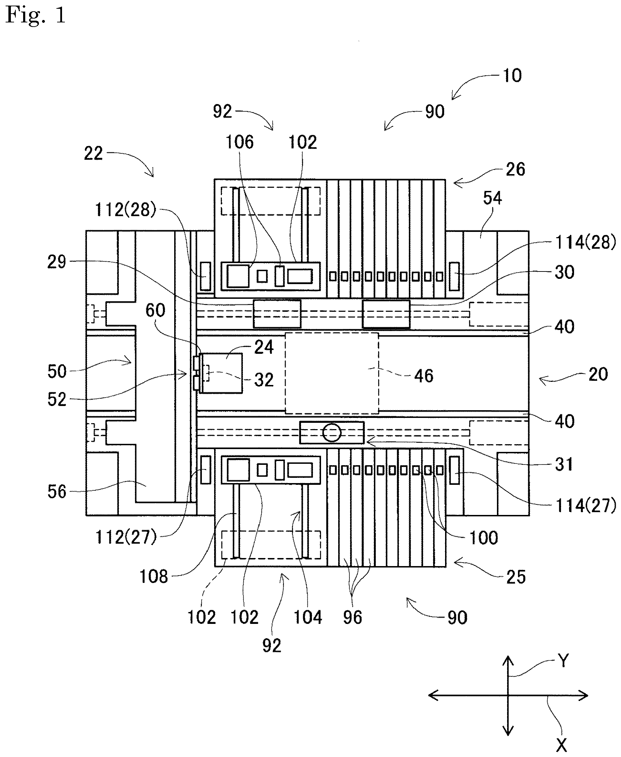

Fig. 1 shows electronic component mounter 10 according to an embodiment of the present invention. Electronic component mounter 10 is a device configured to mount an electronic component on a circuit board. The electronic component mounter 10 includes conveyance device 20, mounting head moving device (hereinafter, also, referred to as a "moving device" from time to time) 22, mounting head 24, a pair of supply devices 25 and 26, a pair of photoelectric sensors 27 and 28, tool station 29, nozzle station 30, part camera 31, and mark camera 32.

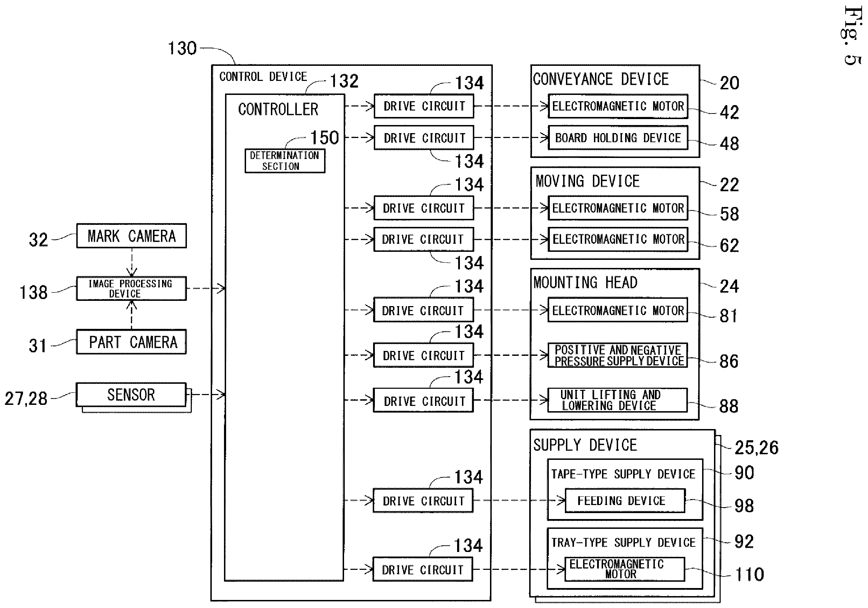

Conveyance device 20 includes a pair of conveyor belts 40 and electromagnetic motor (refer to Fig. 5) 42 that circulates conveyor belts 40. A direction in which the pair of conveyor belts 40 extend is referred to as an X-direction, and a horizontal direction perpendicular to the X-direction is referred to as a Y-direction. Circuit board 46 is supported by pair conveyor belts 40 and is conveyed in the X-direction by driving electromagnetic motor 42. Conveyance device 20 includes board holding device (refer to Fig. 5) 48. Board holding device 48 fixedly holds circuit board 46 supported by conveyor belts 40 in a predetermined position (a position where circuit board 46 is shown in Fig. 1).

Moving device 22 includes X-direction slide mechanism 50 and Y-direction slide mechanism 52. X-direction slide mechanism 50 includes X slider 56 provided movably on base 54 in the X direction. X slider 56 moves to any position in the X-direction by driving electromagnetic motor (refer to Fig. 5) 58. Y-direction slide mechanism 52 includes Y slider 60 provided movably on a side face of X slider 56 in a Y-direction. Y slider 60 moves to any position in the Y-direction by driving electromagnetic motor (see Fig. 5) 62. Mounting head 24 is attached to Y slider 60. The resulting structure allows moving device 22 to move mounting head 24 to any position on base 54.

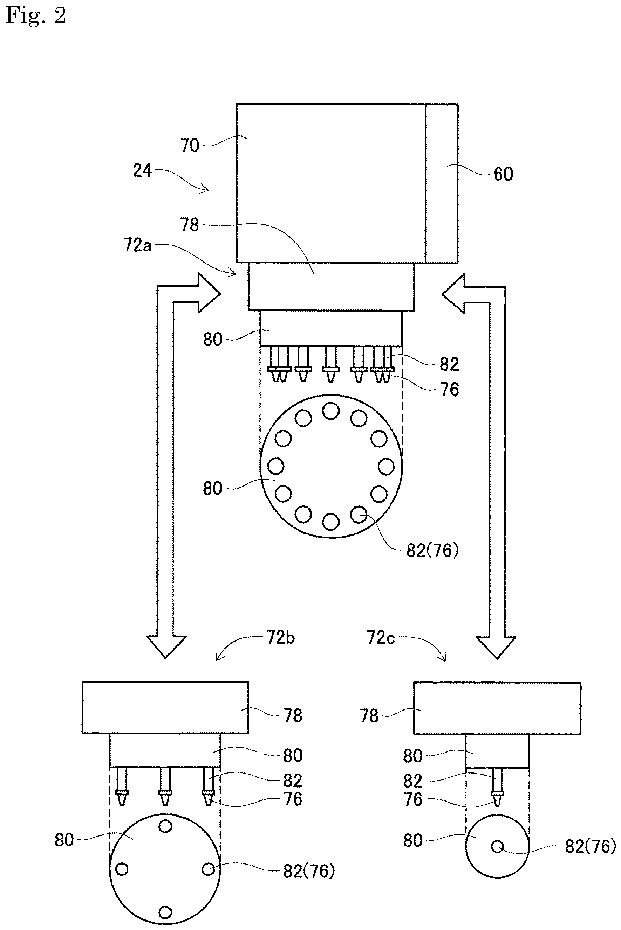

Mounting head 24 mounts an electronic component on the circuit board. As shown in Fig. 2, mounting head 24 is made up of main body section 70 and holding tool 72 and is attached to Y slider 60 of moving device 22 at main body section 70. Holding tool 72 holds one or more suction nozzles 76, and any one of multiple holding tools 72 is detachably mounted on a lower face side of main body section 70. In electronic component mounter 10, three types of holding tools 72a, 72b, and 72c are provided, and when distinguishing between three types of holding tools 72a, 72b, and 72c, holding tool 72a is described as first holding tool 72a, holding tool 72b is described as second holding tool 72b, and holding tool 72c is described as third holding tool 72c.

Retaining tools 72a, 72b, and72 c each have mounting section 78 and unit holding section 80 and are each detachably mounted on the lower face side of main body section 70 at mounting section 78. Unit holding section 80 of each of holding tools 72a, 72b, and 72c is generally cylindrical in shape and is held onto a lower face of mounting section 78. Unit holding section 80 of first holding tool 72a and unit holding section 80 of second holding tool 72b are held by corresponding mounting sections 78 so as to rotate on their own axes and rotate through a predetermined angle at a time by driving electromagnetic motor 81 (refer to Fig. 5).

First holding tool 72a holds 12 mounting units 82 having a generally shaft-like shape at equal angular intervals along an outer circumferential portion. Second holding tool 72b holds four mounting units 82 at equal angular intervals along an outer circumferential portion. Third holding tool 72c holds one mounting unit 82 at a central portion thereof. Each mounting unit 82 is held in such a state that mounting unit 82 extends vertically in an axial direction, and a lower end portion of each mounting unit 82 extends downwards from a lower face of each unit holding section 80. Suction nozzle 76 is detachably mounted at the lower end portion of each mounting unit 82.

Since second holding tool 72b can hold more components than third holding tool 72c, electronic components held by suction nozzles 76 of second holding tool 72b are usually smaller than an electronic component held by suction nozzle 76 of third holding tool 72c. Also, since first holding tool 72a can hold more components than second holding tool 72b, electronic components held by suction nozzles 76 of first holding tool 72a are usually smaller than the electronic components held by suction nozzles 76 of second holding tool 72b. That is, the sizes of the electronic components held by holding tools 72a, 72b, and 72c become smaller sequentially in the order of third holding tool 72c, second holding tool 72b, and first holding tool 72a.

Mounting head 24 includes positive and negative pressure supply device (refer to Fig. 5) 86 and unit lifting and lowering device (refer to Fig. 5) 88. Positive and negative pressure supply device 86 supplies negative pressure air or positive pressure air to each suction nozzle 76 through an air passage. As a result, each suction nozzle 76 picks up and holds an electronic component by the negative pressure air and releases the held electronic component by the positive pressure air. In addition, unit lifting and lowering device 88 lifts and lowers a predetermined one mounting unit 82 of 12 mounting units 82 of first holding tool 72a, a predetermined one mounting unit 82 of four mounting units 82 of second holding tool 72b, or single mounting unit 82 of third holding tool 72c. As a result, operations of holding and mounting an electronic component are performed by suction nozzle 76 mounted on mounting unit 82 that is lifted and lowered accordingly.

As shown in Fig. 1, a pair of supply devices 25 and 26 are disposed on both sides of base 54 in the Y-direction in such a manner as to hold conveyance device 20 therebetween. Supply devices 25 and 26 are each made up of tape-type supply device 90 and tray-type supply device 92.

Tape-type supply device 90 includes multiple tape feeders 96. Tape feeder 96 accommodates taped components disposed therearound. The taped component is a component in which an electronic component is taped. Then, tape feeder 96 supplies electronic components at supply position 100 by delivering a taped component by feeding device (refer to Fig. 5) 98. Tape feeders 96 are detachably attached to base 54 and can cope with exchange of electronic components, shortage of electronic components, and the like.

Tray-type supply device 92 is made up of support plate 102 and slide device 104. Support plate 102 supports multiple component trays 106, and each component tray 106 accommodates multiple electronic components. Component tray 106 generally accommodates electronic components larger than the electronic components supplied by tape feeder 96. Slide device 104 includes a pair of guide rails 108 extending in the Y-direction, and support plate 102 is held slidably in the Y-direction on the pair of guide rails 108. Then, support plate 102 is moved between a supply position (a position where support plate 102 is indicated by a solid line in Fig. 1) and a retraction position (a position where support plate 102 is indicated by a dotted line in Fig. 1) by driving electromagnetic motor (refer to Fig. 5) 110. Thus, while the support plate 102 is staying in the retraction position, component trays 106 are placed on support plate 102, and when support plate 102 is moved to the supply position, tray-type supply device 92 supplies components accommodated in the component trays 106. The supply position of tray-type supply device 92 and supply position 100 of tape feeder 96 substantially coincide with each other in the X-direction. That is, the supply position of tray-type supply device 92 and supply position 100 of tape feeder 96 are arranged on a line extending generally in the X-direction.

A pair of photoelectric sensors 27, 28 are provided for a pair of supply devices 25, 26, respectively. Photoelectric sensors 27, 28 are each made up of irradiation section 112 and light receiving section 114. Irradiation section 112 emits light, and light receiving section 114 receives light emitted from irradiation section 112. With no foreign matter existing between irradiation section 112 and light receiving section 114, light receiving section 114 receives light emitted from irradiation section 112, but with foreign matter existing between irradiation section112 and light receiving section 114, the light emitted from irradiation section 112 is blocked by the foreign matter, whereby an amount of light received by light receiving section 114 decreases. By adopting the structure described above, photoelectric sensors 27, 28 sense foreign matter existing between irradiation section 112 and light receiving section 114, and detect foreign matter existing between irradiation section 112 and light receiving section 114.

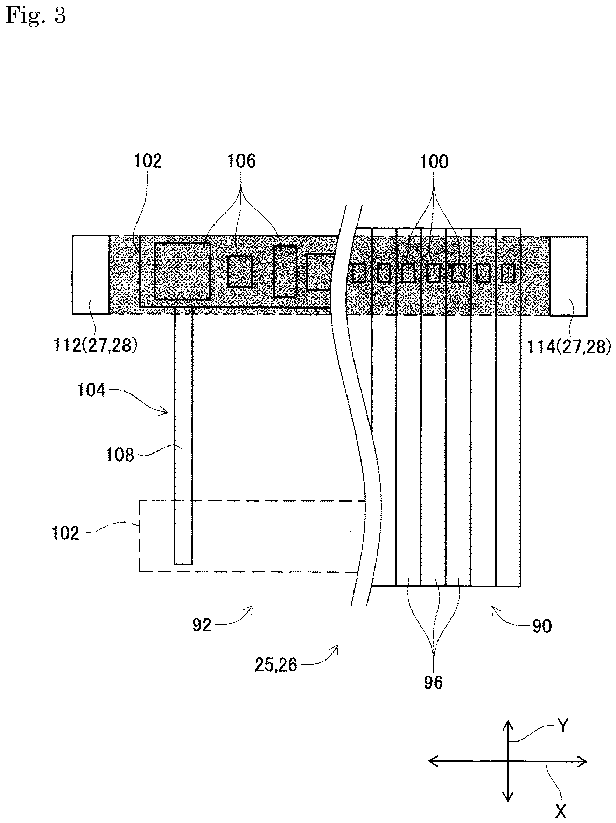

Irradiation section 112 of each of photoelectric sensors 27, 28 is configured to emit light of a predetermined width (60 to 70 mm), and light receiving section 114 is configured to receive light of the predetermined width. Then, as shown in Fig. 3, the light emitted from irradiation section 112 towards light receiving section 114 senses foreign matter existing in a predetermined range including spaces above supply positions where components are supplied by supply devices 25, 26, the supply position of tray-type supply device 92 and supply position 100 of tape feeder 96 (a range shaded in gray in the figure).

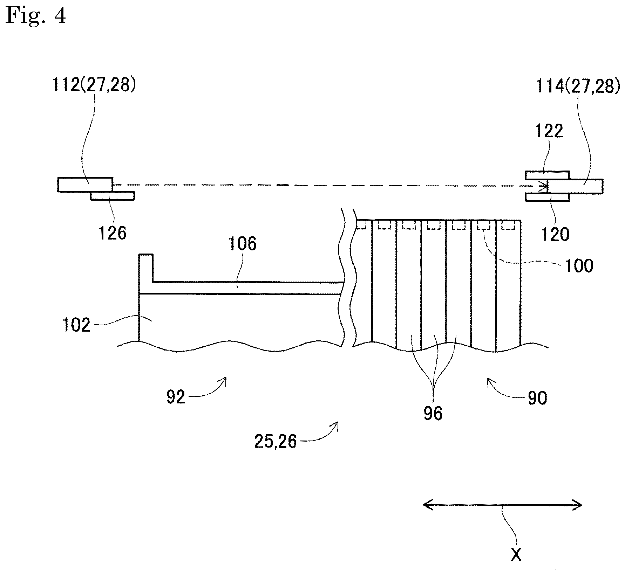

To describe this in detail, irradiation section 112 and light receiving section 114 are disposed at both sides of each of supply devices 25, 26 in the X-direction so as to hold therebetween the component supply positions of each of the supply devices 25, 26. At this time, irradiation section 112 is disposed so that light of the predetermined width becomes horizontal in a width direction, and light receiving section 114 is disposed so as to be capable of receiving light of the predetermined width. As shown in Fig. 4, irradiation section 112 and light receiving section 114 are disposed so that light emitted from irradiation section 112 passes through a position higher by a predetermined dimension than an upper face of supply position 100 of tape feeder 96. As a result, photoelectric sensors 27, 28 sense foreign matter existing in the predetermined ranges including the spaces above the supply positions where the components are supplied by supply devices 25, 26.

Note that, as shown in Fig. 4, lower light blocking plate 120 configured to block the reception of light from below is disposed on a lower face side of light receiving section 114, and upper light blocking plate 122 configured to block the reception of light from above is disposed on an upper face side of light receiving section 114. This can prevent light receiving section 114 from receiving light other than the light emitted from irradiation section 112, thereby ensuring required sensing. Additionally, lower light blocking plate 126 configured to block a downward diffusion of the emitted light is disposed on a lower face side of irradiation section 112. This is because, in the case where the light emitted from irradiation section 112 diffuses downwards, there are caused fears that the diffused light may be reflected by tape feeders 96 or the like to be incident on light receiving section 114. This can prevent light receiving section 114 from receiving light reflected by tape feeders 96 or the like to thereby ensure required sensing. Note that even in the event that light emitted from irradiation section 112 diffuses upwards, since no member that reflects the diffused light is not disposed above supply devices 25, 26, no light blocking plate is disposed on an upper face side of irradiation section 112.

As shown in Fig. 1, tool station 29 is disposed between conveyance device 20 and supply device 26. Multiple tool accommodation sections (not illustrated) are formed on tool station 29, and the tool accommodation sections individually accommodate holding tools 72a, 72b, and 72c. In tool station 29, any one of holding tools 72a, 72b, 72c mounted on main body section 70 of mounting head 24 is exchanged with another of holding tools 72a,72 b, 72c accommodated in the tool station 29 as required.

Nozzle station 30 is disposed next to tool station 29. Multiple nozzle accommodation sections (not illustrated) are formed on nozzle station 30, and suction nozzles 76 are accommodated in the nozzle accommodation sections. In nozzle station 30, suction nozzle 76 or suction nozzles 76 mounted on mounting unit 82 of mounting head 24 are exchanged with suction nozzles 76 or suction nozzle 76 accommodated in nozzle station 30 as required.

Part camera 31 is disposed between conveyance device 20 and supply device 25 while being oriented upwards. As a result, part camera 31 captures an image of an electronic component held by suction nozzle 76 by moving mounting head 24 to stay above part camera 31. Mark camera 32 is fixed to Y slider 60 of moving device 22 while being oriented downwards and moves to any position by operating moving device 22. As a result, mark camera 32 captures an image of any position on base 54.

As shown in Fig. 5, electronic component mounter 10 includes control device 130. Control device 130 includes controller 132 and multiple drive circuits 134. Multiple drive circuits 134 are connected to electromagnetic motors 42, 58, 62, 110, board holding device 48, positive and negative pressure supply device 86, unit lifting and lowering device 88, and feeding device 98. Controller 132 includes a CPU, a ROM, a RAM, and the like and is made up mainly of a computer, being connected to multiple drive circuits 134. As a result, the operations of conveyance device 20, moving device 22, and the like are controlled by controller 132. Controller 132 is also connected to image processing device 138. Image processing device 138 is a device configured to process image data captured by part camera 31 and mark camera 32. Thus, controller 132 acquires various types of information from the captured image data. Further, controller 132 is connected to photoelectric sensors 27. 28, and acquires detection values detected by photoelectric sensors 27, 28.

### Mounting Operation by Electronic Component Mounter

In electronic component mounter 10, a mounting operation is executed on circuit board 46 conveyed by conveyance device 20 based on the configuration described heretofore. During the mounting operation executed on circuit board 46, normally, small components are initially mounted, and then, components of larger sizes are sequentially mounted in an increasing order.

More specifically, when a start button (not illustrated) is operated by the operator, after a calibration of mounting head 24, mounting head 24 moves to stay above part camera 31 in accordance with a command from controller 132, and an image of mounting head 24 is captured by part camera 31. Then, holding tool 72 mounted on main body section 70 of mounting head 24 is confirmed based on the captured image data. That is, it is determined whether holding tool 72 is mounted on main body section 70 of mounting head 24 based on the captured image data imaging data. When it is determined that holding tool 72 is mounted on main body section 70, then, the type of mounted holding tool 72 is confirmed.

Next, when first holding tool 72a is not mounted on main body section 70 of mounting head 24, mounting head 24 moves to stay above tool station 29 in accordance with a command from controller 132, and first holding tool 72a is mounted on main body section 70 at tool station 29. When first holding tool 72a is mounted on main body section 70 of mounting head 24, the mounting operation of mounting first holding tool 72a on main body section 70 at tool station 29 is skipped. Subsequently, mounting head 24 moves to stay above nozzle station 30 in accordance with a command from controller 132, and suction nozzles 76 are mounted on mounting unit 82 of first holding tool 72a at nozzle station 30.

Additionally, in conveyance device 20, circuit board 46 is conveyed to a working position by a command of controller 132, and circuit board 46 is held by board holding device 48 in that position. Next, mark camera 32 moves to stay above circuit board 46 in accordance with a command from controller 132 and captures an image of a fiducial mark or the like applied to circuit board 46. As a result, information on the holding position of circuit board 46 and the like can be obtained.

When the mounting operation with first holding tool 72a is performed, as described above, since relatively small electronic components are mounted, controller 132 commands tape feeder 96 to feed out a taped component and to supply the electronic component at supply position 100. In electronic component mounter 10, a pair of supply devices 25, 26 are provided, and supply device 25 accommodates mounting target electronic components to be mounted on a target circuit board for this mounting work, while supply device 26 accommodates mounting target electronic components to be mounted on a circuit board for the following mounting operation, that is, a circuit board of a different type from the target circuit board of the current mounting operation. Therefore, in this mounting operation, supply device 25, supplies electronic components, whereas supply device 26.supplies no electronic component.

Subsequently, mounting head 24 moves to stay above supply position 100 where an electronic component is supplied by tape feeder 96 to pick up and hold electronic components using suction nozzles 76 in accordance with a command from controller 132. Subsequently, mounting head 24 moves to stay above part camera 31 in accordance with a command from controller 132, so that an images of the electronic components held by suction nozzles 76 are captured by part camera 31. In this way, information on the posture of the component so held is obtained. Then, mounting head 24 moves to stay above circuit board 46 to mount the held electronic component on to circuit board 46 in accordance with a command from controller 132.

Next, when the mounting operation with first holding tool 72a is completed, mounting head 24 moves to stay above nozzle station 30, so that suction nozzles 76 mounted on mounting units 82 are returned to nozzle station 30. Then, mounting head 24 moves to stay above tool station 29, and at tool station 29, first holding tool 72a mounted on main body section 70 is removed, whereas second holding tool 72b is mounted on main body section 70. Subsequently, mounting head 24 moves to stay above nozzle station 30, and suction nozzles 76 are mounted on mounting unit 82 of second holding tool 72b at nozzle station 30.

In addition, mounting target electronic components for a mounting operation with second holding tool 72b become larger in size than those for the mounting operation with first holding tool 72a; however, the mounting target electronic components still remain good enough in terms of size to be supplied with tape feeders 96, and hence, the mounting target electronic components are supplied using tape feeders 96. Due to this, tape feeders 96 of supply device 25 supply electronic components at supply positions 100. Subsequently, mounting head 24 performs a picking up operation of picking up electronic components at supply position 100, and images of the held electronic components are captured by part camera 31. Then, mounting head 24 mounts the electronic components on circuit board 46.

Next, when the mounting operation using second holding tool 72b is completed, mounting head 24 moves to stay above nozzle station 30, and the suction nozzles 76 mounted on mounting unit 82 are returned to nozzle station 30. Then, mounting head 24 moves to stay above tool station 29, and second holding tool 72b mounted on main body section 70 is removed at tool station 29, third holding tool 72 being then mounted on main body section 70. Subsequently, mounting head 24 moves to stay above nozzle station 30, and suction nozzle 76 is mounted on mounting unit 82 of third holding tool 72c at nozzle station 30.

Since a mounting target electronic component for a mounting operation with third holding tool 72c is relatively large, the electronic component is supplied using tray-type supply device 92. Due to this, in tray-type supply device 92 of supply device 25, slide device 104 moves support plate 102 from the retraction position to the supply position. Subsequently, an electronic component is picked up from component tray 106 of support plate 102 that moves to the supply position by mounting head 24, and an image of the held electronic component is captured by part camera 31. Then, mounting head 24 mounts the electronic components on circuit board 46.

Next, when the mounting operation using third holding tool 72c is completed, the holding of circuit board 46 by board holding device 48 is released, so that circuit board 46 is conveyed out of electronic component mounter 10. As a result, circuit board 46 is manufactured on which the electronic components ranging in size from small to large are sequentially mounted. Then, fresh circuit board 46 is conveyed into electronic component mounter 10, and is held by board holding device 48 in the working position.

When the mounting operation using third holding tool 72c is completed, mounting head 24 moves to stay above nozzle station 30, and suction nozzle 76 mounted on mounting unit 82 is returned to nozzle station 30. Then, to start a mounting operation on fresh circuit board 46, mounting head 24 moves to stay above tool station 29, third holding tool 72c mounted on main body section 70 is removed at tool station 29, and first holding tool 72a is then mounted on main body section 70. The following steps will be the same as those described above, and hence, the description thereof will be omitted here.

### Fallen Component Determination Operation

As described above, in electronic component mounter 10, the electronic component supplied to the supply position of tape feeder 96 or tray-type supply device 92 is picked up by suction nozzle 76, and the electronic component so held is then mounted on the circuit board. However, there may be a case where suction nozzle 76 fails to properly pick up an electronic component so that the electronic component falls on or near the supply position. In such a case, mounting head 24 may come into contact with the electronic component fallen on or near a pickup position when mounting head 24 moves to above the pickup position to allow suction nozzle 76 to pick up the electronic component. In view of the situations described above, in electronic component mounter 10, photoelectric sensors 27, 28 each sens an electronic component that may exist in a predetermined range including a space above the electronic component supply position to determine whether an electronic component exists in the predetermined range.

Specifically, as described above, irradiation section 112 of each of photoelectric sensors 27, 28 emits light towards the predetermined range including the space above the electronic component supply position, and the emitted light is then received by corresponding light receiving section 114 of each of photoelectric sensors 27, 28. Therefore, in the event that an electronic component falls between irradiation section 112 and light receiving section 114, that is, in the predetermined range including the space above the electronic component supply position, the light emitted by irradiation section 112 is blocked by the electronic component, so that the amount of light received by light receiving section 114 decreases. Due to this, whether an electronic component exists in the predetermined range including the space above the electronic component supply position can be determined by sensing the existence of an electronic component in the predetermined range including the space above the electronic component supply position by photoelectric sensors 27, 28. Then, when it is determined that an electronic component exists in the predetermined range, the operation of electronic component mounter 10 is stopped for removal of the electronic component, so that mounting head 24 can be prevented from coming into contact with the fallen electronic component. The operation of determining whether an electronic component exists the predetermined range including the space above the electronic component supply position using each of photoelectric sensors 27, 28 may be described as a component existence determination operation.

However, in the case where the component existence determination operation is executed when suction nozzle 76 picks up an electronic component from the supply position, light emitted from irradiation section 112 is blocked by suction nozzle 76, and the electronic component held by suction nozzle 76, resulting in an erroneous determination that an electronic component exists in the predetermined range. Due to this, the component existence determination operation is executed at a timing other than a timing at which suction nozzle 76 picks up an electronic component at the supply position. Specifically, the component existence determination operation is executed in an intervening period from when an electronic component has been picked up by suction nozzle 76 at the supply position until another electronic component is picked up by suction nozzle 76 at the supply position after the previously picked up electronic component is mounted, that is, between one component picking up operation and another component picking up operation.

Although the component existence determination operation may be executed at all times between one component picking up operation and another component picking up operation, labor hours involved in programming the component existence determination operation can be reduced by executing the component existence determination operation in association with a predetermined operation. Therefore, electronic component mounter 10 is programed so that after electronic components are picked up by suction nozzles 76, a component confirmation operation is performed in association with an operation of capturing images of the electronic components using part camera 31. That is, in electronic component mounter 10, the component existence determination operation is executed at a timing at which an image of an electronic component held by suction nozzle 76 is captured by part camera 31 after the electronic component is picked up by suction nozzle 76. As a result, not only the labor hours involved in programming can be reduced, but also the existence of an electronic component that falls during a picking up operation from suction nozzle 76 can be determined at a preferred timing.

As described above, however, with third holding tool 72c mounted on main body section 70 of mounting head 24, a relatively large electronic component is mounted. Due to this, an electronic component for use for the mounting operation is supplied by tray-type supply device 92, causing fears that an electronic component supplied at the supply position of tray-type supply device 92 blocks light emitted from irradiation section 112, whereby photoelectric sensors 27, 28 are prevented from executing a proper sensing.

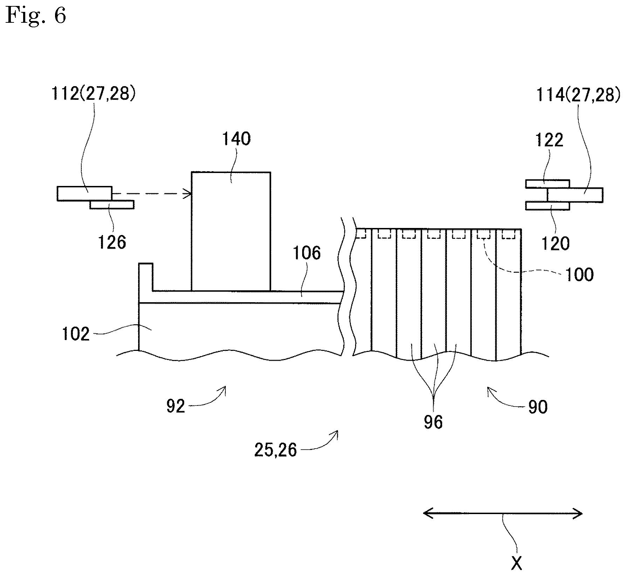

Specifically, in the case where an electronic component is supplied by tray-type supply device 92, as shown in Fig. 6, electronic component 140 is rested on component tray 106, and component tray 106 is moved to the supply position. As this occurs, depending on the dimensions of electronic component 140 resting on component tray 106, that is, supplying target electronic component 140, light emitted from irradiation section 112 may be blocked by electronic component 140 from time to time. In such a case, it is constantly determined that an electronic component falls within the predetermined range, photoelectric sensors 27, 28 are prevented from executing proper sensing. Due to this, in the case of a mounting target electronic component for a mounting operation using third holding tool 72c (hereinafter, also, referred to as "third holding tool target component" from time to time) being rested on component tray 106, and component tray 106 being moved to the supply position, the component existence determination operation is not executed. That is, the component existence determination operation for an image capturing operation of an electronic component by part camera 31 is not executed during the mounting operation using third holding tool 72c.

Moving component tray 106, on which a third holding tool target compoent is rested to the supply position, prevents photoelectric sensors 27, 28 from executing proper sensing, as described above. Due to this, component tray 106, on which third holding tool target component is rested, is not moved to the supply position but is kept staying in the retraction position during the mounting operation using first holding tool 72a and during the mounting operation using second holding tool 72b. That is, component tray 106 is restricted from moving to the supply position until the mounting operation using second holding tool 72b is completed, and component tray 106 is moved to the supply position after the mounting operation using second holding tool 72b is completed. Then, component tray 106 is returned to the retraction position after the mounting operation using third holding tool 72c is executed and the mounting operation using third holding tool 72c is completed. As a result, photoelectric sensors 27, 28 can execute proper sensing during the mounting operation using first holding tool 72a and during the mounting operation using second holding tool 72b.

In electronic component mounter 10, electronic components differing relatively wide in size, that is, including from small components to large components can be mounted on circuit board 46 by exchanging holding tools 72 that are mounted on main body section 70 of mounting head 24. However, in the event that suction nozzle 76 fails to properly pick up an electronic component so that the electronic component falls on or near the supply position, mounting head 24 may come into contact with the fallen electronic component in association with exchange of holding tools 72.

Specifically, when mounting electronic components on single circuit board 46, a mounting operation using first holding tool 72a, a mounting operation using second holding tool 72b, and a mounting operation using third holding tool 72c are sequentially executed. When the series of mounting operations on single circuit board 46 is completed, a similar series of mounting operations to the mounting operations executed on previous circuit board 46 is executed on next single circuit board 46. That is, a mounting operation using first holding tool 72a, a mounting operation using second holding tool 72b, and a mounting operation using third holding tool 72c are executed sequentially and repeatedly.

In this process, if a third holding tool target component, namely, an electronic component for use in the mounting operation using third holding tool 72c, falls on or near the pickup position, the fallen third holding tool target component may be left unused because the component existence determination operation is not executed during the mounting operation using third holding tool 72c as described above. The third holding tool target component is a relatively large component. In this regard, third holding tool 72c mounted on the main body section 70 of mounting head 24 is designed to hold a third holding tool target component of a large size, and thus, even though the third holding tool target component falls on or near the pickup position, third holding tool 72c is less likely to come into contact with the third holding tool target component, which falls on or near the pickup position, when mounting head 24 moves.

However, first holding tool 72a and second holding tool 72b are designed to hold an electronic component of a smaller size than the third holding tool target component, and thus if the third holding tool target component falls on or near the pickup position, first holding tool 72a or second holding tool 72b can come into contact with the third holding tool target component when first holding tool 72a or second holding tool 72b is mounted on main body section 70 of mounting head 24.

In view of this, when holding tool 72 mounted on main body section 70 of mounting head 24 is exchanged, a component existence determination operation is executed. In the case where third holding tool 72c is mounted on main body section 70, third holding tool 72c is less likely to come into contact with an electronic component fallen on or near the pickup position. Therefore, a component existence determination operation is executed at a timing at which holding tool 72 mounted on main body section 70 of mounting head 24 is exchanged with first holding tool 72a or second holding tool 72b, that is, immediately after first holding tool 72a or second holding tool 72b is mounted on main body section 70 of mounting head 24. This can prevent mounting head 24 coming into contact with an electronic component, which would otherwise occur in association with the exchange of holding tools 72.

Additionally, in electronic component mounter 10, a component existence determination operation is also executed at a timing at which a circuit board is started to be manufactured, that is, at a timing at which the operator operates a start button. This makes it possible to check the presence or absence of an electronic component fallen during the manufacturing operation on the previous day or the like. Further, a component existence determination operation is also executed at a timing at which a determination operation is executed on holding tool 72 mounted on main body section 70 of mounting head 24 based on image data obtained when an image of mounting head 24 is captured after the start button is operated. As a result, this can further ensure the checking of the presence or absence of a fallen electronic component.

Thus, as has been described heretofore, in electronic component mounter 10m, a pair of supply devices 25, 26 are provided, and in executing the mounting operation described above, supply device 25 supplies the electronic components, while supply device 26 supplies no electronic component. Due to this, a setup operation such as exchange of tape feeders 96 is executed in supply device 26. However, when a component existence determination operation is executed by supply device 26, that is, when a component existence determination operation is executed using photoelectric sensor 28 provided for supply device 26, the exchange of tape feeders 96 may cause the misrecognition that a component has fallen, so that the operation of electronic component mounter 10 may come to a stop. In view of the occurrence of such unpreferable situations, the component existence determination operation during the mounting operation is executed using photoelectric sensor 27 provided for supply device 25, and no component existence determination operation using photoelectric sensor 28 provided for supply device 25 is executed. This enables tape feeders 96 to be exchanged in supply device 26 while the mounting operation is being executed, thereby improving the operation efficiency.

As shown in Fig. 5, controller 132 includes determination section 150. Determination section 150 constitutes a function section configured to execute a component existence determination operation using photoelectric sensors 27, 28, that is, functions to determine whether a component exists within the predetermined range including the component supply position.

Incidentally, in the embodiment described heretofore, electronic component mounter 10 constitutes an example of a mounting machine. Conveyance device 20 constitutes an example of a conveyance device. Mounting head 24 constitutes an example of a mounting head. Supply devices 25, 26 constitute an example of a supply device. Photoelectric sensors 27, 28 constitute are an example of a sensor. Tool station 29 constitutes an example of an exchanging device. Main body section 70 constitutes an example of a main body section. Holding tool 72 constitutes an example of a mounting section. Suction nozzle 76 constitutes an example of a holding tool. Irradiation section 112 constitutes an example of an irradiation section. Light receiving section 114 constitutes an example of a light receiving section. Lower light blocking plate 126 constitutes an example of a light blocking section. Control device 130 constitutes an example of a control device. Determination section 150 constitutes an example of a determination section.

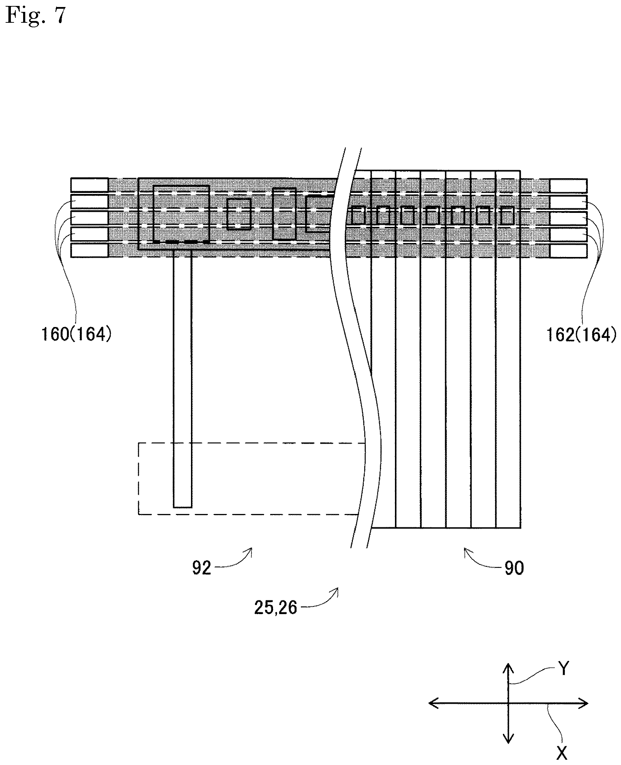

It should be noted that the present invention is not limited to the embodiment described heretofore and can be carried out in various modes in which various modifications and improvements are made thereto based on the knowledge of those skilled in the art to which the present invention pertains and as long as they fall under the scope of the invention, which is defined by the appended claims. Specifically, for example, in the embodiment that has been described heretofore, the predetermined range is sensed for existence of a component using photoelectric sensors 27 and 28 configured to emit light of a wide width; however, the predetermined range may be sensed for existence of a component using multiple photoelectric sensors configured to emit light of a narrow width. Specifically, as shown in Fig. 7, multiple photoelectric sensors 164, each made up of an irradiation section 160 configured to emit light of a narrow width and a light receiving section 162 configured to receive such light of a narrow width, are adopted, and multiple irradiation sections 160 are disposed at a first side of both sides of each of supply devices 25, 26 in the X-direction in such a manner as to emit light over a whole surface of the predetermined range. In addition, multiple light receiving sections 162 are disposed at a second side of both the sides of each of supply devices 25, 26 in the X-direction in such a manner as to receive light emitted from multiple irradiation sections 160. The predetermined range can be sensed for existence of a component by arranging multiple photoelectric sensors 164 in the way described above.

In the embodiment described above, while the component existence determination operation is described as being executed when part camera 31 captures images of electronic components or when holding tools 72 are exchanged, the component existence determination operation can be executed at various timings other than the timing at which suction nozzles 76 pick up an electronic component. Specifically, for example, there are raised a timing at which an electronic component held by suction nozzle 76 is mounted on circuit board 46, a timing at which suction nozzle 76 or suction nozzles 76 are mounted on holding tool 72, a timing at which circuit board 46 is conveyed, and the like.

In the embodiment described above, while lower light blocking plate 126 is disposed only on the lower face side of irradiation section 112, lower light blocking plate 126 can be disposed on an upper face side and the lower face side of irradiation section 112.

### Reference Signs List

10: Electronic component mounter (mounting machine) 20 : conveyance device 24 : mounting head 25 : supply device 26 : supply device 27 : photoelectric sensor (sensor) 28 : photoelectric sensor (sensor) 29 : tool station (exchanging device) 70 : main body section 72 : holding tool (mounting section) 76 : suction nozzle (holding tool) 112 : irradiation section 114 : light receiving section 126 : lower light blocking plate (light blocking section) 130 : control device 150 : determination section

## Claims

1. A mounting machine (10) comprising:
a first supply device (25, 26) configured to supply a component at a supply position
a mounting head (24) including a holding tool (76) configured to hold a component supplied by the supply device (25, 26);
a first sensor (28) configured to detect foreign matter in a predetermined range including a space above the supply position (100); and
a control device (130) including a determination section (150) configured to determine whether foreign matter exists in the predetermined range based on a result of a detection executed by the sensor (27) at a timing other than a timing at which the holding tool (76) performs a picking up operation at the supply position
**characterized in that**
the determination section (150) is configured to determine whether foreign matter exists in the predetermined range based on a result of a detection executed by the sensor (27) in an intervening period from when a component has been picked up by the holding tool (76) at the supply position until another component is picked up by the holding tool (76) at the supply position after the previously picked up component is mounted.

2. The mounting machine according to claim 1,
wherein the mounting head (24) comprises:
a main body section (70); and
a mounting section (72) including one or more holding tools (76), the mounting section (72) being detachably mounted on the main body section (70),
the mounting machine further comprising an exchanging device (29) having an accommodation section for accommodating a different mounting section (72) that is a mounting section (72) that is different from the mounting section (72) mounted on the main body section (70), the different mounting section (72) including a different number of the holding tools (76) from the number of the holding tools (76) included in the mounting section (72) mounted on the main body section (70), the exchanging device (29) being configured to exchange the mounting section (72) mounted on the main body section (70) with the different mounting section (72) accommodated in the accommodation section, wherein
the determination section (150) is configured to determine whether foreign matter exists in the predetermined range based on a result of a detection executed by the sensor (27) after the exchanging device (29) exchanges the mounting section (72) mounted on the main body section (70) with the different mounting section (72) accommodated in the accommodation section.

3. The mounting machine according to claim 1 or 2, further comprising:
a conveyance device (20) configured to convey a board; and
a pair of the supply devices (25, 26) provided in such a manner as to hold the conveyance device (20) therebetween, wherein
when a component supplied from the first supply device (25, 26) of the pair of the supply devices (25, 26) is picked up by the holding tool (76), the determination section (150) determines whether foreign matter exists in the predetermined range for the first supply device (25, 26) of the pair of the supply devices (25, 26) but does not determine whether foreign matter exists in the predetermined range for a second supply device (25, 26) of the pair of the supply devices (25, 26).

4. The mounting machine according to any one of claims 1 to 3,
wherein the sensor (27) comprises:
an irradiation section (112) configured to emit light; and
a light receiving section (114) configured to receive light emitted from the irradiation section (112), and
a light blocking section (126) is provided to block downward diffusion of light emitted from the irradiation section (112).

## Patentansprüche

1. Montage-Maschine (10), die umfasst:
eine erste Zuführvorrichtung (25, 26), die so ausgeführt ist, dass sie ein Bauteil an einer Zuführposition zuführt;
einen Montage-Kopf (24), der ein Haltewerkzeug (76) enthält, das so ausgeführt ist, dass es ein von der Zuführvorrichtung (25, 26) zugeführtes Bauteil hält;
einen ersten Sensor (28), der so ausgeführt ist, dass er Fremdkörper in einem vorgegebenen Bereich einschließlich eines Raums oberhalb der Zuführposition (100) erfasst; sowie
eine Steuerungsvorrichtung (130), die einen Feststellungs-Teilabschnitt (150) enthält, der so ausgeführt ist, dass er auf Basis eines Ergebnisses einer Erfassung, die durch den Sensor (27) zu einem anderen Zeitpunkt als einem Zeitpunkt ausgeführt wird, zu dem das Haltewerkzeug (76) einen Vorgang zum Aufnehmen an der Zuführposition durchführt, feststellt, ob sich Fremdkörper in dem vorgegebenen Bereich befinden,
**dadurch gekennzeichnet, dass**
der Feststellungs-Teilabschnitt (150) so ausgeführt ist, dass er auf Basis eines Ergebnisses einer Erfassung, die durch den Sensor (27) in einer Zwischenzeit zwischen dem Zeitpunkt, zu dem ein Bauteil durch das Haltewerkzeug (76) an der Zuführposition aufgenommen wird, bis zu dem Zeitpunkt ausgeführt wird, zu dem ein anderes Bauteil durch das Haltewerkzeug (76) an der Zuführposition aufgenommen wird, nachdem das zuvor aufgenommene Bauteil montiert ist, feststellt, ob Fremdkörper in dem vorgegebenen Bereich vorhanden sind.

2. Montage-Maschine nach Anspruch 1,
wobei der Montage-Kopf (24) umfasst:
einen Hauptkörper-Teilabschnitt (70); sowie
einen Montage-Teilabschnitt (72), der ein oder mehrere Haltewerkzeug/e (76) enthält, wobei der Montage-Teilabschnitt (72) abnehmbar an dem Hauptkörper-Teilabschnitt (70) angebracht ist,
die Montagemaschine des Weiteren eine Austauschvorrichtung (29) mit einem Aufnahme-Teilabschnitt zum Aufnehmen eines anderen Montage-Teilabschnitts (72) umfasst, der ein Montage-Teilabschnitt (72) ist, der sich von dem an dem Hauptkörper-Teilabschnitt (70) angebrachten Montage-Teilabschnitt (72) unterscheidet, wobei der andere Montage-Teilabschnitt (72) eine andere Anzahl von Haltewerkzeugen (76) als die Anzahl der Haltewerkzeuge (76) enthält, die in dem an dem Hauptkörper-Teilabschnitt (70) angebrachten Montage-Teilabschnitt (72) enthalten sind, und die Austauschvorrichtung (29) so ausgeführt ist, dass sie den an dem Hauptkörper-Teilabschnitt (70) angebrachten Montageabschnitt gegen den anderen Montage-Teilabschnitt (72) austauscht, der in dem Aufnahme-Teilabschnitt aufgenommen ist, und
der Feststellungs-Teilabschnitt (150) so ausgeführt ist, dass er auf Basis eines Ergebnisses einer Erfassung, die durch den Sensor (27) ausgeführt wird, nachdem die Austauschvorrichtung (29) den an dem Hauptkörper-Teilabschnitt (70) angebrachten Montage-Teilabschnitt (72) gegen den in dem Aufnahmeabschnitt aufgenommenen anderen Montage-Teilabschnitt (72) ausgetauscht hat, feststellt, ob Fremdkörper in dem vorgegebenen Bereich vorhanden sind.

3. Montage-Maschine nach Anspruch 1 oder 2, die des Weiteren umfasst:
eine Fördervorrichtung (20), die zum Fördern einer Platine ausgeführt ist; sowie
ein Paar der Zuführvorrichtungen (25, 26), die so eingerichtet sind, dass die Fördervorrichtung (20) zwischen ihnen gehalten wird, wobei
wenn ein von der ersten Zuführeinrichtung (25, 26) der paarigen Zuführvorrichtungen (25, 26) zugeführtes Bauteil von dem Haltewerkzeug (76) aufgenommen wird, der Feststellungs-Teilabschnitt (150) für die erste Zuführvorrichtung (25, 26) der paarigen Zuführeinrichtungen (25, 26) feststellt, ob Fremdkörper in dem vorgegebenen Bereich vorhanden sind, jedoch für eine zweite Zuführvorrichtung (25, 26) der paarigen Zuführvorrichtungen (25, 26) nicht feststellt, ob Fremdkörper in dem vorgegebenen Bereich vorhanden sind.

4. Montage-Maschine nach einem der Ansprüche 1 bis 3,
wobei der Sensor (27) umfasst:
einen Bestrahlungs-Teilabschnitt (112), der zum Emittieren von Licht ausgeführt ist, sowie
einen Teilabschnitt (114) zum Empfangen von Licht, der so ausgeführt ist, dass er von dem Bestrahlungs-Teilabschnitt (112) emittiertes Licht empfängt, sowie
einen Teilabschnitt (126) zum Sperren von Licht, der so eingerichtet ist, dass er Abwärtsdiffusion des von dem Bestrahlungs-Teilabschnitt (112) emittierten Lichtes sperrt.

## Revendications

1. Machine de montage (10) comprenant :
un premier dispositif d'alimentation (25, 26) configuré pour alimenter un composant à une position d'alimentation ;
une tête de montage (24) comprenant un outil de maintien (76) configuré pour maintenir un composant alimenté par le dispositif d'alimentation (25, 26) ;
un premier capteur (28) configuré pour détecter une substance étrangère dans une plage prédéterminée comprenant un espacé au-dessus de la position d'alimentation (100) ; et
un dispositif de contrôle (130) comprenant une section de détermination (150) configurée pour déterminer si une substance étrangère est présente ou non dans la plage prédéterminée sur la base du résultat d'une détection exécutée par le capteur (27) à un moment autre que le moment où l'outil de maintien (76) met en œuvre une opération de saisie à la position d'alimentation,
**caractérisée en ce que**
la section de détermination (150) est configurée pour déterminer si une substance étrangère est présente ou non dans la plage prédéterminée sur la base du résultat d'une détection exécutée par le capteur (27) dans une période intermédiaire depuis le moment où un composant a été saisi par l'outil de maintien (76) à la position d'alimentation jusqu'au moment où un autre composant est saisi par l'outil de maintien (76) à la position d'alimentation après que le composant saisi précédemment est monté.

2. Machine de montage selon la revendication 1,
dans laquelle la tête de montage (24) comprend :
une section de corps principale (70) ; et
une section de montage (72) comprenant un ou plusieurs outils de maintien (76), la section de montage (72) étant montée de manière détachable sur la section de corps principale (70),
la machine de montage comprenant en outre un dispositif d'échange (29) comportant une section de logement pour loger une section de montage différente (72), qui est une section de montage (72) différente de la section de montage (72) montée sur la section de corps principale (70), la section de montage différente (72) comprenant un nombre d'outils de maintien (76) différent du nombre d'outils de maintien (76) inclus dans la section de montage (72) montée sur la section de corps principale (70), le dispositif d'échange (29) étant configuré pour échanger la section de montage (72) montée sur la section de corps principale (70) avec une section de montage différente (72) logée dans la section de logement,
dans laquelle la section de détermination (150) est configurée pour déterminer si une substance étrangère est présente ou non dans une plage prédéterminée sur la base du résultat d'une détection exécutée par le capteur (27) après que le dispositif d'échange (29) échange la section de montage (72) montée sur la section de corps principale (70) avec la section de montage différente (72) logée dans la section de logement.

3. Machine de montage selon la revendication 1 ou 2, comprenant en outre :
un dispositif de convoyage (20) configuré pour convoyer une carte ; et
une paire de dispositifs d'alimentation (25, 26) pourvus de manière à maintenir entre eux le dispositif de convoyage (20), dans laquelle
quand un composant alimenté par le premier dispositif d'alimentation (25, 26) de la paire de dispositifs d'alimentation (25, 26) est saisi par l'outil de maintien (76), la section de détermination (150) détermine si une substance étrangère est présente ou non dans la plage prédéterminée pour le premier dispositif d'alimentation (25, 26) de la paire de dispositifs d'alimentation (25, 26) mais ne détermine pas si une substance étrangère est présente ou non dans la plage prédéterminée pour un deuxième dispositif d'alimentation (25, 26) de la paire de dispositifs d'alimentation (25, 26).

4. Machine de montage selon l'une quelconque des revendications 1 à 3, dans laquelle
le capteur (27) comprend :
une section d'irradiation (112) configurée pour émettre de la lumière ; et
une section de réception de lumière (114) configurée pour recevoir la lumière émise par la section d'irradiation (112), et
une section de blocage de lumière (126) est pourvue pour bloquer la diffusion vers le bas de la lumière émise par la section d'irradiation (112).
